# EUROPEAN PATENT APPLICATION

(11) **EP 4 761 476 A1**
(43) Date of publication of application: **17.06.2026**
(21) Application number: 24219217.7
(22) Date of filing: 11.12.2024
(51) Int. Cl.: H05K 3/34, H05B 47/18, B60R 16/023, H04L 12/40, H05K 1/18

(54) **ELECTRONIC SUBSTRATE AND AUTOMOTIVE LUMINOUS DEVICE FOR INTERIOR LIGHTING**

(71) Applicant: Valeo Vision, 93012 Bobigny Cedex (FR)
(72) Inventor: HERNANDEZ-CLEDERA, Manuel, 23600 MARTOS (ES); SANTAELLA, Juan-Jose, 23600 MARTOS (ES)
(74) Representative: Valeo Visibility

(57) **Abstract**

This invention is related to an electronic substrate for an automotive lighting device. The electronic substrate comprises a a first side and a second side opposite to the first side, a power input (1), a communication bus input (2), at least a first layer (6) on the first side of the substrate (5), and a second layer (7) on the second side of the substrate (5); a first transceiver circuit having a first footprint (8) arranged on the first layer (6) and connected to the power input (1) and a second transceiver circuit having a second footprint (9) different from the first (8) being arranged on the second layer (7) and connected to the power input (1). One of the first transceiver (8) or the second transceiver (9) is connected to the communication bus input (2).

## Description

### FIELD OF THE INVENTION

This invention is related to the field of automotive interior lighting, and more particularly, to the improvement of the electronic substrate used for interior lighting devices.

### BACKGROUND OF THE INVENTION

Automotive lighting market can be considered one of the most competitive ones and new lighting functionalities are constantly required.

Automotive vehicles have interior light sources, which are in charge of providing interior lighting when needed. In current automotive vehicles, these interior lights are used to customize the appearance of the interior of the vehicle, and are increasingly used in doors, dashboards, roofs and so on.

This means that the space available for these devices is reduced, and they must provide a good optical performance with this reduced space. The electronics of this kind of luminous devices include normally a printed circuit board (PCB) with the electronics, and a number of pins, which receive information from a connector which communicates information from the BCM. For example, the PCB may have four pins, each pin configured to receive VCC, GND, LIN_in and LIN_out. The connector configuration and the functional requirements of the PCB are provided by the car manufacturer, and the design and way of providing information may be different from one manufacturer to another.

In view of the above, there is a need in the field of providing a single PCB which can be utilized to perform different functional requirements of different manufacturers without unnecessarily redesigning the layout of the PCB.

### BRIEF DESCRIPTION OF THE INVENTION

The present invention overcomes the above limitations of the prior art, by providing an electronic substrate for an automotive luminous device according to the invention.

In a first inventive aspect, the invention provides an electronic substrate for an automotive lighting device, the electronic substrate comprising:
a first side and a second side opposite to the first side;
at least a first communication bus input;
at least a first layer on the first side of the substrate and a second layer on the second side of the substrate;
a first transceiver circuit arranged on the first layer;
a second transceiver circuit which is different from the first transceiver circuit and is arranged on the second layer; and
wherein
the first transceiver circuit comprises a first footprint configured to receive a transceiver, wherein the first footprint comprises a first communication connection and wherein the first transceiver circuit is further configured to electrically connect the first communication connection to the first communication bus input;
the second transceiver circuit comprises a second footprint configured to receive the transceiver, wherein the second footprint comprises a second communication connection and wherein the second transceiver circuit is further configured to electrically connect the second communication connection to the first communication bus input;
the projection of the first footprint over the circuit substrate has at least a portion in common with the projection of the second footprint over the electronic substrate; and
the transceiver comprises a communication input which is arranged in electric contact with the first communication connection and/or with the second communication connection.

A footprint or land pattern is an arrangement of pad connections (in surface-mount technology) or through-hole connections (in through-hole technology) used to physically attach and electrically connect a component (in this case a transceiver) to a circuit substrate.

This electronic substrate comprises two different transceiver circuits which are arranged in the same circuit substrate. Only one of them will be actually used in the operation of the automotive vehicle, since only one transceiver will be installed in the circuit substrate (only one of the footprints is populated with a transceiver). As a consequence, this invention allows the use of a single electronic substrate to provide functional requirements to different car manufacturers. Some car manufacturers may require the installation of the transceiver in connection with the first transceiver circuit (i.e., in the first footprint), and other car manufacturers may require the installation of the transceiver in connection with the second transceiver circuit (i.e., in the second footprint). Regardless of the transceiver that is chosen, the electronic arrangement will operate for the specific transceiver installed in the circuit substrate, since communication connections of both circuits are connected to the main communication bus input of the circuit substrate.

Due to the fact that the first transceiver circuit is installed in one layer and the second transceiver circuit is installed in a different layer, it is possible to save space in the final circuit substrate, since the footprints of each transceiver may overlap, either partially or totally.

In some particular embodiments, the first communication connection and the second communication connection are electrically connected.

In these cases, both circuits comprise a common portion and two bifurcations: one end closes the circuit of the first communication connection and the other end closes the circuit of the second communication connection. Hence, when the transceiver is installed in the first or in the second circuit, the installed transceiver makes electric connection with the common portion by means of the corresponding bifurcation. Since only one transceiver is installed, the bifurcation that is not connected to any transceiver remains open, without being used.

In fact, in some cases, one of the two circuits may be as simple as a via, since it is possible that the common portion is placed in one layer, and arrives at the corresponding communication connection, and the bifurcation is a simple via, which connects the communication connection of one footprint with the other communication connection, located in the other layer (i.e., in the other footprint). This will only be possible if both communication connections are vertically aligned, as will be seen below.

In some particular embodiments, the substrate further comprises a power supply input and
the first transceiver circuit comprises a first power supply connection and an electric connection which connects the first power supply connection to the power supply input, either directly or by means of a voltage regulator; and
the second transceiver circuit comprises a second power supply connection and an electric connection which connects the second power supply connection to the power supply input, either directly or by means of a voltage regulator.

The first and second transceivers are not usually connected to the power input directly, since the voltage usually needs to be adapted from 12 V to 5 V. In those cases, an intermediate stage such as a linear regulator LDO or a DC/DC converter is configured between the corresponding transceiver and the power input.

The circuit substrate may be a two-layer or three layer or four-layer or multi-layered printed circuit board. The number of layers in the PCB may be used to create multiple circuit paths without electric contact between the different circuit paths. The multi-layered PCB is useful when one conductive track must cross a different conductive track of another circuit path without contacting. Further, vias are used to change the electric path from one layer to another, to make this crossing without contact possible.

In some particular embodiments, the substrate is configured to turn ON one of the first or second transceiver circuits as a response of a signal received from a control unit. In an embodiment, the control unit may be a microcontroller, or a headlight driver. In another embodiment, the control unit may be triggered by a Body Control Module(BCM). In another embodiment, the control unit may be the BCM. The control unit may provide the signal based on the variant of the automotive vehicle.

In some particular embodiments, the circuit substrate is a rigid printed circuit board, such as a FR4 printed circuit board or an insulated metal substrate printed circuit board.

A FR4 printed circuit board has a top layer which is a continuous copper plane. This first outer layer would act as the first conductive plane of the invention, without the need of a further first conductive plane. An insulated metal substrate (IMS) has a metal baseplate (aluminium is commonly used because of its low cost and density) covered by a thin layer of dielectric (usually an epoxy-based layer) and a layer of copper. Compared to a classical printed circuit board, the IMS provides a better heat dissipation. It is one of the simplest ways to provide efficient cooling to surface mount components.

In some particular embodiments, the circuit substrate is a flexible printed circuit board.

A rigid substrate should be understood in the sense of what the skilled person would construe. A skilled person knows the difference between a rigid substrate and a flexible substrate. Although every material is "flexible" in the sense that it has a stress-strain curve, a substrate which does not apparently deform by its own weight when held by one of its ends is deemed to be rigid, while a substrate which suffer a substantial deformation when held by one of its ends is considered to be flexible. Despite the fact that every plastic material is «flexible», there is a big difference between the elastic properties of a flexible printed circuit board, which may achieve deformations so that different portion of the same surface may form 90 degrees with each other without permanent deformation, which is impossible for a rigid printed circuit board without breaking. In any case, board manufacturers offer a "flexible" model and a "rigid" model, so any skilled person knows the difference between them.

In some particular embodiments, the first transceiver circuit is configured to perform a Controller Area Network (CAN) communication function, and the second transceiver circuit is configured to perform a Local Interconnect Network (LIN) communication function. This ensures that a single electronic circuit substrate design could be used to perform different communication functions. The different functional requirements of different automotive vehicle manufacturers could be met by using a single substrate design.

In some particular embodiments, the transceiver circuit comprises a voltage regulator.

A system basis chip (SBC) comprises a transceiver together with the corresponding voltage regulator. This allows a better operation of the communications transceiver and allows direct connection between the circuit and the power input, without the interposition of a further voltage regulator.

In some particular embodiments,
the first footprint further comprises a first GND connection
the second footprint further comprises a second GND connection
the first communication connection and the second communication connection are connected by means of an electronic arrangement which comprises, at least, a first via; and
the first GND connection and the second GND connection are connected by means of an electronic arrangement which comprises, at least, a second via.

In some particular embodiments, the projection of the first footprint on the circuit substrate coincides with the projection of the second footprint over the circuit substrate.

This is the optimal case, where the size of the substrate is reduced to the minimum.

In some particular embodiments,
the projection of the first GND connection on the circuit substrate coincides with the projection of the second GND connection on the circuit substrate;
the projection of the first communication connection on the circuit substrate coincides with the projection of the second communication connection on the circuit substrate;
the first GND connection and the second GND connection are directly connected by means of a first via;
the first communication connection and the second communication connection are directly connected by means of a second via.

In this specific cases, a simple via is enough to achieve the electric contact between the symmetrical connections, so that the connection of an external connector pin to one of these pins is enough to achieve the connection to the corresponding communication connection. In those cases where the projection does not coincide, a combination of a jumper (0 ohm resistor) with a via will be enough to achieve this electric connection.

In some particular embodiments, the communication bus input is connected to a control unit, such as an ECU or a headlight driver or a microcontroller unit.

The electronic substrate may be connected to a local control unit or to the general control unit of the vehicle (Body Control Module BCM).

In a second inventive aspect, the invention provides an automotive luminous device for interior lighting of an automotive vehicle, the lighting device comprising:
an electronic substrate according to the first inventive aspect;
a solid-state light source; and
a driver element arranged in electric connection with the solid-state light source and configured to manage the operation of the solid-state light source.

The term "solid state" refers to light emitted by solid-state electroluminescence, which uses semiconductors to convert electricity into light. Compared to incandescent lighting, solid state lighting creates visible light with reduced heat generation and less energy dissipation. The typically small mass of a solid-state electronic lighting device provides for greater resistance to shock and vibration compared to brittle glass tubes/bulbs and long, thin filament wires. They also eliminate filament evaporation, potentially increasing the lifespan of the illumination device. Some examples of these types of lighting comprise semiconductor light-emitting diodes (LEDs), organic light-emitting diodes (OLED), or polymer light-emitting diodes (PLED) as sources of illumination rather than electrical filaments, plasma or gas. These light sources are specifically advantageous, since they provide the required luminous properties for the automotive regulations with a high efficiency and reliability.

In some particular embodiments, the at least one light source is configured to cooperate to provide an interior lighting function.

Lighting or signalling functions which require a reduced space will receive a higher benefit from this invention, since heat dissipation requirements are met without the need of substantially increasing the size of the electronic circuit.

In some particular embodiments, the automotive luminous device further comprises an optical element configured to receive the light emitted by the solid-state light source.

An optical element is an element that has some optical properties to receive a light beam and emit it in a certain direction and/or shape, as a person skilled in automotive lighting would construe without any additional burden. Reflectors, collimators, light guides, projection lenses, etc., or the combination thereof are some examples of these optical elements which are useful for transforming the light beams emitted by the light source into an acceptable light pattern for the functionality chosen for the lighting device.

In some particular embodiments, the optical element is a lightguide or a reflector or a massive light guide.

Depending on the shape and position of the interior light, a tube-type light guide, a massive light guide or a simple reflector will be the best option to achieve the projection of the light emitted by the light sources.

In some particular embodiments, the solid-state light source and the driver element are installed in the circuit substrate. In other particular embodiments, the automotive luminous device further comprises a second circuit substrate, wherein the light source is arranged in the second circuit substrate, and the light source is connected to the driver element by means of a harness.

All the terms and embodiments described anywhere in this document are equally applicable to all aspects of the invention. It should be noted that, as used in the specification and in the appended claims, the singular forms "a", "an", and "the" include their plural referents unless the context clearly indicates otherwise. Similarly, the term "comprises" or "comprising" as used herein also describes "consists of" or "consisting of" in accordance with generally accepted patent practice.

### DESCRIPTION OF THE DRAWINGS

The foregoing and other features and advantages will be more fully understood from the detailed description of the invention, as well as from examples referring to the attached figures, which are described in the following paragraphs, wherein:
Figure 1 shows a luminous device according to the invention installed in an automotive vehicle.
Figure 2 shows a general approach of a particular embodiment of a luminous device according to the invention.
Figure 3 shows the electronic substrate of a particular embodiment of a luminous device according to the invention.
Figure 4 shows a top view of a particular embodiment of an electronic substrate according to the invention.
Figure 5 shows a lateral view of the embodiment of Figure 4, which shows aspects of the connection between the pins of the different transceivers.
Figure 6 shows a top view of another particular embodiment of an electronic substrate according to the invention.
Figure 7 shows a lateral view of the embodiment of Figure 6, which shows the connection between the pins of the different transceivers.
Figure 8 shows an alternative embodiment of the invention, which is compatible with all the embodiments shown in Figures 4, 5, 6 and 7.

### DETAILED DESCRIPTION OF THE INVENTION

The detailed description of the present invention to be described below refers to the accompanying drawings, which illustrate specific embodiments in which the present invention may be implemented. These embodiments will be described in detail sufficient to enable those skilled in the art to implement the present invention. It should be understood that various embodiments of the present invention are different from each other but need not be mutually exclusive. Accordingly, the detailed description to be described below is not intended to be taken in a limiting meaning, and the scope of the present invention, if properly described, is limited only by the appended claims, in addition to all scopes equivalent to those claimed by the appended claims. In the drawings, reference numerals refer to the same or similar functions over several aspects.

Hereinafter, preferred embodiments of the present invention will be described in more detail with reference to the accompanying drawings.

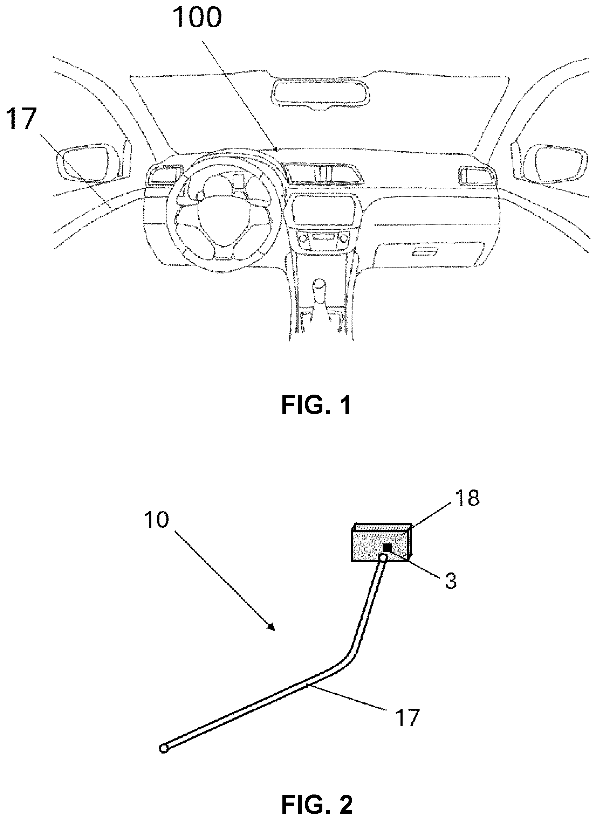

Figure 1 shows a luminous device according to the invention installed in an automotive vehicle 100.

This luminous device comprises a plurality of light emitting diodes (LEDs) which emit light and a light guide 17 which projects the light to the interior of the automotive vehicle 100.

Figure 2 shows a general approach of a particular embodiment of a luminous device according to the invention.

As can be seen in this figure, the luminous device 10 comprises a RGB module 18 which comprises the electronic substrate including a group of LEDs 3. These LEDs 3 emit light which is projected by the lightguide 17. The RGB module 18 receives the power supply and instructions from a vehicle connector which receives communication from the Body Control Module.

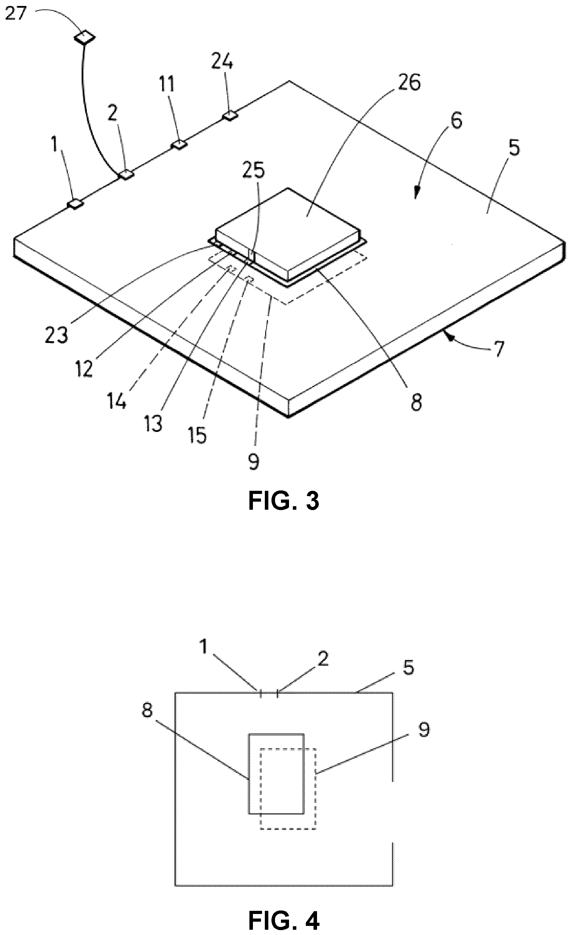

Figure 3 shows the electronic substrate of a particular embodiment of a luminous device according to the invention.

This electronic substrate comprises a power input 1, a communication bus input 2, a ground input 11 and a first printed circuit board (PCB) 5. This first PCB 5 is a rigid PCB, and in particular, it is a FR4 printed circuit board. However, other types of rigid PCBs or even flexible PCBs may be used for this purpose. To simplify the illustration of the present invention, this first PCB 5 only comprises a first layer 6, which is located in the first side of the PCB 5, and a second layer 7, which is located in the second side that is opposite to the first side of the PCB 5. However, a more complex type of PCB may be used in different embodiments.

A first transceiver circuit having a first footprint 8, is configured to configured to receive a transceiver (26). The transceiver is arranged on the first layer 6 to perform a Controller Area Network (CAN) communication function. The first footprint 8 comprises a first ground pad 12 and a first communication pad 13 and is configured to receive a CAN transceiver. Because CAN transceivers use two communication pads (CAN_H and CAN_L), the first footprint 8 also comprises an auxiliary communication pad 23.

The first transceiver circuit is configured to connect the first communication pad 13 to the first communication bus input 2. In this particular example, this first transceiver circuit also provides an electric communication between the auxiliary communication pad 23 and a second communication bus input 24 located in the PCB 5.

A second transceiver circuit having a second footprint 9, is configured to receive the transceiver (26). The transceiver is arranged on the second layer 7 toperform a Local Interconnect Network (LIN) communication function. The second footprint 9 comprises a second ground pad 14 and a second communication pad 15 and is configured to receive a LIN transceiver.

The second transceiver circuit is configured to connect the second communication pad 15 to the first communication bus input 2.

Other types of transceiver footprints may be used in this invention (e.g., a Clock Extension Peripheral Interface, CXPI), either by replacing one of the previous footprints or by adding them, in a separate layer or in the same layer as any one of the previous footprints. However, only one of the footprints is populated by the transceiver.

In some embodiments, instead of a simple transceiver, the chosen footprint is configured to receive a system basis chip (SBC). This SBC comprises, not only the transceiver (LIN or a CAN), but also the corresponding voltage regulator. This allows a simpler layout of the PCB 5.

The communication bus input 2 is connected to a control unit 27, which can be a local control unit, such as a headlight driver or a microcontroller unit, or may be the central control unit of the vehicle, such as an ECU or a BCM (Body Control Module).

In an embodiment, the footprint that is populated by the transceiver is the first footprint 8, where a LIN transceiver 26 is installed. The LIN transceiver 26 comprises a communication input 25 which is set in contact with the first communication pad 13.

Figure 4 shows a top view of a particular embodiment of such an electronic arrangement.

A top view of the electronic arrangement shows how the projection of the first footprint 8 on the PCB 5 has a portion in common with the projection of the second footprint 9 (which is seen as dashed line, since it is in the bottom part of the arrangement) over the PCB 5. These projections do not coincide entirely, but it is enough to save much space in the PCB 5, since there is no need to place the two different footprints in the same face.

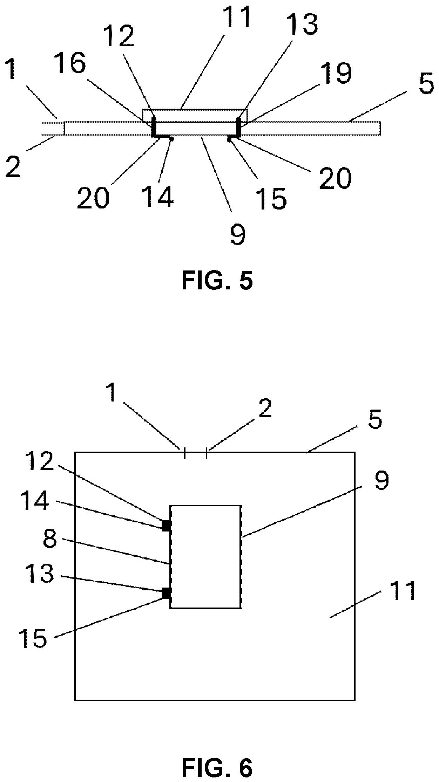

Figure 5 shows a lateral view of the embodiment of Figure 4, which shows aspects of the connection between the pins of the different transceivers.

In this invention, the first GND pad 12 and the second GND pad 14 are connected by means of a first via 16 and a jumper 20, while the first communication pad 13 and the second communication pad 15 are connected by means of a second via 19 and a jumper 20.

In an embodiment, the jumper 20 is a zero ohm resistor that can be Surface Mounted (SMD) on the PCB to close the circuit. In another embodiment, the jumper is a zero ohm resistor that can be mounted on the PCB by a through hole. In another embodiment, the jumper can be a cable.

Figure 6 shows a particular embodiment of such an electronic substrate.

This is a particular example where the footprint projections coincide and the projections of the pads which are intended to perform the same function also coincide. As can be seen in the figure, the projection of the first footprint 8 on the PCB 5 coincides with the projection of the second footprint 9 over the PCB 5. Further, the projection of the first GND pad 12 coincides with the projection of the second GND pad 14 and the projection of the first communication pad 13 coincides with the projection of the second communication pad 15.

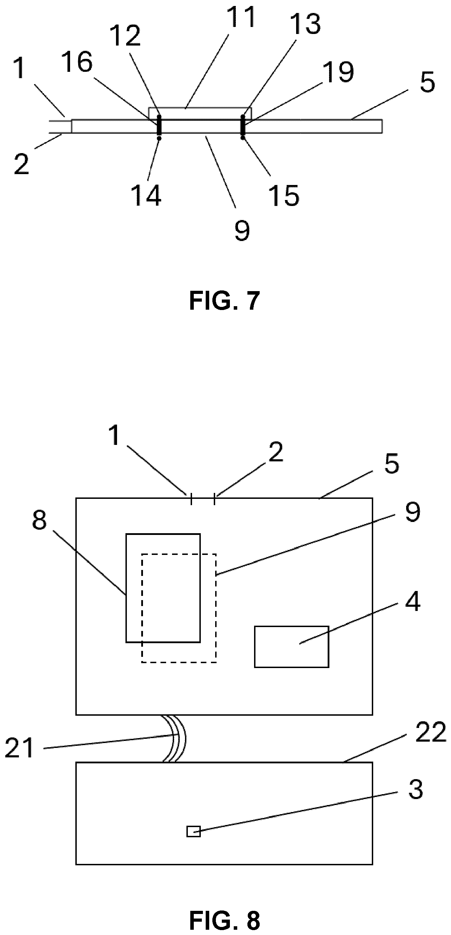

Figure 7 shows a lateral view of the embodiment of Figure 6.

In this case, since the projection of the first GND pad 12 on the PCB 5 coincides with the projection of the second GND pad 14 on the PCB 5, the first GND pad 12 and the second GND 14 pad are directly connected by means of a first via 16. It is sufficient to have a via since the position of the first GND pad 12 and the position of the second GND pad 14 are vertically aligned.

The first communication pad 13 and the second communication pad 15 are in the similar alignment, so they are also connected by means of a second via 19.

Figure 8 shows an alternative embodiment of the invention, which is compatible with all the embodiments shown in Figures 4, 5, 6 and 7.

In this case, the LED 3 is not located in the same printed circuit board as the rest of the main elements of the invention (communication bus input, first and second footprints), but is located in a further printed circuit board 22, which is connected to the first printed circuit board 5 by means of a harness 21. The driver 4 is located in the first printed circuit board and is in charge of controlling the operation of the LED 3.

### Numerical references used in the drawings

In order to provide a better understanding of the technical features of the invention, the following numerical references have been used:

| | |
|---|---|
| 1 | Power input |
| 2 | Communication bus input |
| 3 | LED |
| 4 | Driver element |
| 5 | First PCB |
| 6 | First layer |
| 7 | Second layer |
| 8 | First footprint |
| 9 | Second footprint |
| 10 | Luminous device |
| 11 | Ground input |
| 12 | First GND pad |
| 13 | First communication pad |
| 14 | Second GND pad |
| 15 | Second communication pad |
| 16 | First via |
| 17 | Lightguide |
| 18 | RGB module |
| 19 | Second via |
| 20 | Jumper |
| 21 | Harness |
| 22 | Second PCB |
| 23 | Auxiliary communication pad |
| 24 | Second communication bus input |
| 25 | Communication input of the transceiver |
| 26 | Transceiver |
| 27 | Control Unit |
| 100 | Automotive vehicle |

## Claims

1. An electronic substrate (5) for an automotive lighting device, the substrate (5) comprising:
a first side and a second side opposite to the first side;
at least a first communication bus input (2);
at least a first layer (6) on the first side of the substrate (5), and a second layer (7) on the second side of the substrate (5);
a first transceiver circuit arranged on the first layer (6);
a second transceiver circuit that is different from the first transceiver circuit is arranged on the second layer (7); and
wherein
the first transceiver circuit comprises a first footprint (8) configured to receive a transceiver (26), wherein the first footprint (8) comprises a first communication connection (13) and wherein the first transceiver circuit is further configured to electrically connect the first communication connection (13) to the first communication bus input (2);
the second transceiver circuit comprises a second footprint (9) configured to receive the transceiver (26), wherein the second footprint (9) comprises a second communication connection (15) and wherein the second transceiver circuit is further configured to electrically connect the second communication connection (15) to the first communication bus input (2);
the projection of the first footprint (8) over the circuit substrate (5) has at least a portion in common with the projection of the second footprint (9) over the electronic substrate (5); and
the transceiver (26) comprises a communication input (25) that is arranged in electric contact with the first communication connection (13) and/or with the second communication connection (15).

2. Electronic substrate (5) according to claim 1, wherein the first communication connection (13) and the second communication connection (15) are electrically connected .

3. Electronic substrate (5) according to any of the preceding claims, wherein the substrate further comprises a power supply input (1) and
the first transceiver circuit (8) comprises a first power supply connection and an electric connection which connects the first power supply connection to the power supply input, either directly or by means of a voltage regulator; and
the second transceiver circuit (9) comprises a second power supply connection and an electric connection which connects the second power supply connection to the power supply input, either directly or by means of a voltage regulator.

4. Electronic substrate (5) according to any of the preceding claims, wherein the substrate is configured to turn ON one of the first or second transceiver circuits as a response of a signal received from a control unit (27).

5. Electronic substrate (5) according to any of the preceding claims, wherein the circuit substrate (5) is a rigid printed circuit board, such as a FR4 printed circuit board or an insulated metal substrate printed circuit board.

6. Electronic substrate (5) according to any of claims 1 to 3, wherein the circuit substrate (5) is a flexible printed circuit board.

7. Electronic substrate (5) according to any of the preceding claims, wherein the first transceiver circuit is configured to perform a Controller Area Network (CAN) communication function, and the second transceiver circuit is configured to perform a Local Interconnect Network (LIN) communication function.

8. Electronic substrate (5) according to any of the preceding claims, wherein the transceiver (26) comprises a voltage regulator.

9. Electronic substrate (5) according to any of the preceding claims, wherein
the first footprint (8) further comprises a first GND connection (12);
the second footprint (9) further comprises a second GND connection (14);
the first communication connection (13) and the second communication connection (15) are connected by means of an electronic arrangement which comprises, at least, a first via (16); and
the first GND connection (12) and the second GND connection (14) are connected by means of an electronic arrangement which comprises, at least, a second via (19).

10. Electronic substrate (5) according to any of the preceding claims, wherein the projection of the first footprint (8) on the circuit substrate (5) coincides with the projection of the second footprint (9) over the circuit substrate (5).

11. Electronic substrate (5) according to claim 10, wherein
the projection of the first GND connection (12) on the circuit substrate (5) coincides with the projection of the second GND connection (14) on the circuit substrate (5);
the projection of the first communication connection (13) on the circuit substrate (5) coincides with the projection of the second communication connection (14) on the circuit substrate (5);
the first GND connection (12) and the second GND connection (14) are directly connected by means of a first via (16);
the first communication connection (13) and the second communication connection (15) are directly connected by means of a second via (19).

12. Electronic substrate (5) according to any of the preceding claims, wherein the communication bus input (2) is connected to the control unit (27), such as an ECU or a headlight driver or a microcontroller unit.

13. Automotive luminous device for interior lighting of an automotive vehicle, the lighting device comprising:
an electronic substrate (5) according to any of the preceding claims;
a solid-state light source (3);
a driver element (4) arranged in electric connection with the solid-state light source (3) and configured to manage the operation of the solid-state light source (3); and
an optical element (17) configured to receive the light emitted by the solid-state light source (3), wherein the optical element is a lightguide or a reflector or a massive light guide.

14. Automotive luminous device according to claim 13, wherein the solid-state light source (3) and the driver element (4) are installed in the circuit substrate (5).

15. Automotive luminous device according to claim 13, further comprising a second circuit substrate (22), wherein the light source (3) is arranged in the second circuit substrate (22), and the light source (3) is connected to the driver element by means of a harness (21).
